# EUROPEAN PATENT APPLICATION

(11) **EP 1 351 290 A2**
(43) Date of publication of application: **08.10.2003**
(21) Application number: 03100705.7
(22) Date of filing: 19.03.2003
(51) Int. Cl.: H01L 21/768

(54) **Methods for forming vias and trenches with controlled SiC etch rate and selectivity**

(30) Priority: 19.03.2002 US 102504
(71) Applicant: Texas Instruments Incorporated, Dallas, Texas 75251 (US)
(72) Inventor: Jiang, Ping, 75024, Plano (US); Kraft, Rob, 75025, Plano (US); Newton, Kenneth Joseph, Texas, 75070 (US)
(74) Representative: Holt, Michael

(57) **Abstract**

Methods are disclosed for forming vias and trenches through silicon carbide and dielectric materials for interconnection of electrical devices in a semiconductor product, wherein etch chemistry hydrogen content is controlled so as to achieve desired SiC etch rate and selectivity during trench or via etch (10,205, 208), as well as during hard mask (8) or etch-stop layer etch (12,212).

## Description

### FIELD OF INVENTION

The present invention relates generally to semiconductor devices and more particularly to methods for forming vias and trenches in interconnect layers in the fabrication of semiconductor devices.

### BACKGROUND OF THE INVENTION

In the manufacture of semiconductor products such as integrated circuits, individual electrical devices are formed on or in a semiconductor substrate, and are thereafter interconnected to form circuits. Interconnection of these devices within an integrated circuit is typically accomplished by forming a multi-level interconnect network in layers formed over the electrical devices, by which the device active elements are connected to other devices to create the desired circuits. Individual wiring layers within the multi-level network are formed by depositing an insulating or dielectric layer over the discrete devices or over a previous interconnect layer, and patterning and etching contact openings such as vias. Conductive material, such as tungsten is then deposited into the vias to form inter-layer contacts. A conductive layer may then be formed over the dielectric layer and patterned to form wiring interconnections between the device vias, thereby creating a first level of basic circuitry. Dielectric material is then deposited over the patterned conductive layer, and the process may be repeated any number of times using additional wiring levels laid out over additional dielectric layers with conductive vias therebetween to form the multi-level interconnect network.

As device densities and operational speeds continue to increase, reduction of the delay times in integrated circuits is desired. These delays are related to the resistance of interconnect metal lines through the multi-layer interconnect networks as well as the capacitance between adjacent metal lines. In order to reduce the resistivity of the interconnect metal lines formed in metal layers or structures, recent interconnect processes have employed copper instead of aluminum. However, difficulties have been encountered in patterning (etching) deposited copper to form wiring patterns. Furthermore, copper diffuses rapidly in certain types of insulation layers, such as silicon dioxide, leading to insulation degradation and/or copper diffusion through the insulation layers and into device regions.

Copper patterning difficulties have been avoided or mitigated through the use of single or dual damascene processes in which trenches are formed (etched) in a dielectric layer. Copper is then deposited into the trenches and over the insulative layer, followed by planarization using a chemical mechanical polishing (CMP) process to leave a copper wiring pattern including the desired interconnect metal lines inlaid within the dielectric layer trenches. In a single damascene process copper trench patterns are thus created which connect to pre-existing underlying vias, whereas in a dual damascene process, both vias and the trenches are filled at the same time using single copper deposition and CMP steps.

Copper diffusion issues have been addressed using copper diffusion barriers formed between the copper and the dielectric layers as well as between the copper and the silicon substrate. Such barriers are typically formed using conductive compounds of transition metals such as tantalum nitride, titanium nitride, and tungsten nitride as well as the various transition metals themselves. Insulators such as silicon nitride and silicon oxynitride have also been used as barrier materials between copper metallurgy and insulative layers. More recently, silicon carbide (SiC) has been used as a copper diffusion barrier material, as well as etch-stop layers and hard masks used during trench and/or via cavity formation.

RC delay times have also been addressed by recent developments in low dielectric constant (low-k) dielectric materials formed between the wiring metal lines, in order to reduce the capacitance therebetween and consequently to increase circuit speed. Examples of low-k dielectric materials include the spin-on-glasses (SOGs), as well as organic and quasi-organic materials such as polysilsesquioxanes, fluorinated silica glasses (FSGs) and fluorinated polyarylene ethers. Totally organic, non silicaceous materials such as the fluorinated polyarylene ethers, are seeing an increased usage in semiconductor processing technology because of their favorable dielectric characteristics and ease of application. Other low-k insulator materials include organo-silicate-glasses (OSGs), for example, having dielectric constants (k) as low as about 2.6-2.8, and ultra low-k dielectrics having dielectric constants below 2.5. OSG materials are low density silicate glasses to which alkyl groups have been added to achieve a low-k dielectric characteristic.

Single and dual damascene processes using OSG, FSG, or ultra low-k dielectric materials, SiC materials, and copper metals can thus be employed to increase speed, reduce cross-talk, and reduce power consumption in modern high-speed, high-density devices. However, incorporating these newer materials into workable semiconductor fabrication processes presents additional challenges. Among these are the formation of damascene structures, including vias and trenches. In particular, it is desirable to provide accurate etching of trenches and vias through the dielectric layers to properly interconnect electrical devices such as transistors, memory cells, and the like to take advantage of the potential performance benefits of such newer interconnect network materials.

### SUMMARY OF THE INVENTION

The invention relates to etching techniques for formation of vias, trenches, and the like for interconnecting electrical devices in the fabrication of integrated circuits. The invention provides for selective or controlled employment of hydrogen in etch processes used to form such structures by which improved or controllable SiC etch rates and etch selectivities can be achieved in processes using copper conductor materials, organo-silicate-glass (OSG), FSG, or other low or ultra low-k dielectric materials, and silicon carbide (SiC) mask, etch-stop, and/or diffusion barrier materials. In one application, the invention may be employed to refine etch processes involving removal of OSG FSG, or ultra low-k dielectric material in forming trenches and vias where SiC is used as an etch-stop or hard mask layer. In addition, the invention facilitates improvement in etch rates and/or etch selectivities in removal of SiC etch-stop or hard mask material. In accordance with the invention, the inventors have appreciated that controlling hydrogen content in such etch processes may provide controllability and refinement of etch process performance.

In one aspect of the invention, etch processes substantially to totally free of hydrogen are employed to remove dielectric layer material, such as OSG, FSG, or ultra low-k dielectric, where an underlying SiC material is used as an etch-stop layer. The inventors have found that limiting or avoiding the hydrogen content in such etch processing improves the selectivity to SiC. Once the SiC etch-stop material has been exposed, another etch process employing one or more hydrogen-containing gasses may be used to provide selectivity to OSG or other dielectric material. In this regard, the inventors have further appreciated that the inclusion of hydrogen in the etch chemistry advantageously improves the selectivity to OSG, FSG, or ultra low-k dielectric materials. Etch processes employing one or more hydrogen-containing gasses may further be used in removing material from an overlying SiC hard mask layer. The improved etch selectivities and controlled etch rates achievable using the invention may be employed to provide accurate and repeatable formation of damascene and other interconnect structures, including vias, and/or trenches, used to interconnect electrical devices in integrated circuits.

To the accomplishment of the foregoing and related ends, the following description and annexed drawings set forth in detail certain illustrative aspects and implementations of the invention. These are indicative of but a few of the various ways in which the principles of the invention may be employed. Other aspects, advantages and novel features of the invention will become apparent from the following detailed description of the invention when considered in conjunction with the drawings.

### BRIEF DESCRIPTION OF THE DRAWINGS

Fig. 1A is a flow diagram illustrating an exemplary method of forming vias in a semiconductor device in accordance with an aspect of the present invention;
Fig. 1B is a flow diagram further illustrating a dielectric removal step of the method of Fig. 1A;
Fig. 2 is a partial cross-sectional side view illustrating an exemplary semiconductor device having a conductive copper feature formed thereon;
Fig. 3 is a partial cross-sectional side view illustrating formation of a lower silicon carbide etch-stop layer over the device of Fig. 2;
Fig. 4 is a partial cross-sectional side view illustrating formation of a dielectric layer over the device of Figs. 2 and 3;
Fig. 5 is a partial cross-sectional side view illustrating formation of an upper silicon carbide hard-mask layer over the device of Figs. 2-4;
Fig. 6 is a partial cross-sectional side view illustrating formation of a bottom anti-reflection coating layer (BARC) over the device of Figs. 2-5;
Fig. 7 is a partial cross-sectional side view illustrating a resist pattern over the device of Figs. 2-6;
Fig. 8 is a partial cross-sectional side view illustrating a first etch process to etch an exposed portion of the BARC and the upper silicon carbide material in a prospective via region of the device of Figs. 2-7;
Fig. 9 is a partial cross-sectional side view illustrating a main-etch step of a second etch process removing a first portion of the exposed dielectric layer in the prospective via region of the device of Figs. 2-8;
Fig. 10 is a partial cross-sectional side view illustrating an over-etch step of the second etch process substantially to totally free of hydrogen to remove a remaining second portion of the dielectric material in the device of Figs. 2-9;
Fig. 11 is a partial cross-sectional side view illustrating a third etch process employing hydrogen-containing gas to remove the lower silicon carbide etch-stop layer in the prospective via region of the device of Figs. 2-10;
Fig. 12 is a partial cross-sectional side view illustrating a copper diffusion barrier formed in the via of the device of Figs. 2-11;
Fig. 13 is a partial cross-sectional side view illustrating copper material formed in the via of the device of Figs. 2-12; and
Fig. 14 is a partial cross-sectional side view illustrating CMP planarization of the device of Figs. 2-13;
Fig. 15A is a flow diagram illustrating another exemplary method of forming dual damascene via and trench in a semiconductor device in accordance with the present invention;
Fig. 15B is a flow diagram further illustrating a via dielectric removal step of the method of Fig. 15A;
Fig. 16 is a partial cross-sectional side view illustrating another exemplary semiconductor device having a low-k dielectric layer deposited over a substrate as part of a dual damascene process in accordance with another aspect of the invention;
Fig. 17 is a partial cross-sectional side view illustrating a via etch process in accordance with the invention in the device of Fig. 16;
Fig. 18 is a partial cross-sectional side view illustrating a trench patterning and BARC layer formation in the device of Figs. 16 and 17;
Fig. 19 is a partial cross-sectional side view illustrating an etch process for forming a trench in the device of Figs. 16-18;
Fig. 20 is a partial cross-sectional side view illustrating a cleanup process to remove the residual photoresist, and the BARC on the top of the hard mask as well as inside the via in the device of Figs. 18-19; and
Fig. 21 is a partial cross-sectional side view illustrating an etch-stop etch process in the device of Figs. 16-20.

### DETAILED DESCRIPTION OF THE INVENTION

The present invention will now be described with reference to the attached drawings, wherein like reference numerals are used to refer to like elements throughout. The invention relates to etching processes and techniques used in forming vias, trenches and other openings during interconnect processing of integrated circuits and other devices. One or more implementations of the invention are hereinafter illustrated and described in the context of trench and via formation in organo-silicate-glass (OSG) structures, where silicon carbide (SiC) etch-stop and hard mask layers are used, for later filling with copper. However, it will be appreciated by those skilled in the art that the invention is not limited to the exemplary implementations illustrated and described hereinafter. In particular, the various aspects of the invention may be employed in association with processing of devices using OSG, FSG, or other low-k or ultra low-k dielectric materials.

One aspect of the invention provides methods for forming vias or trenches, which may be practiced as part of a process involving the formation of one or more interconnect layers or levels, where the vias and trenches are used to connect electrical signals from one interconnect level to another. In a first such level, vias may be formed through an OSG or other type dielectric layer so as to provide electrical connection to active regions of electrical devices formed on or in a semiconductor substrate. Metal connection layer features are then formed, such as through copper deposition in damascene trench structures having connection to the vias. Further interconnect levels may then be constructed using copper filled vias to connect electrical signals to such layers as needed to implement a desired circuit. The invention may also be employed in dual damascene processes where vias are filled with copper material at the same time the trenches are filled.

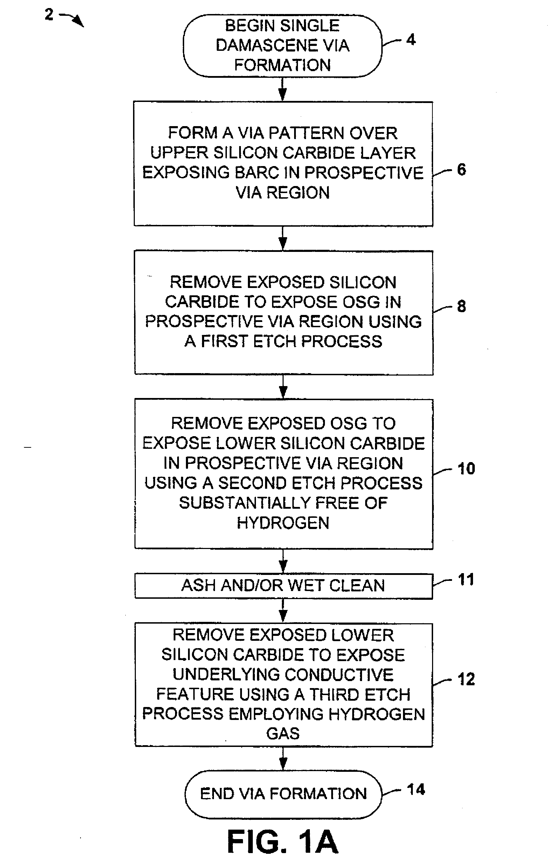

Fig. 1A illustrates one exemplary method 2 for forming a single damascene via in accordance with the present invention, wherein hydrogen content may be advantageously controlled in one or more etch steps used in creating a via cavity or opening. The inventors have appreciated that controlling hydrogen content in such etch processes advantageously facilitates control and/or improvement in etch rates and etch selectivities between SiC materials used in etch-stop layers and hard mask layers, and dielectric materials, such as OSG or others used in forming insulation or dielectric layers.

While the method 2 and other methods herein are illustrated and described below as a series of acts or events, it will be appreciated that the present invention is not limited by the illustrated ordering of such acts or events. For example, some acts may occur in different orders and/or concurrently with other acts or events apart from those illustrated and/or described herein, in accordance with the invention. In addition, not all illustrated steps may be required to implement a methodology in accordance with the present invention. Furthermore, the methods according to the present invention may be implemented in association with the formation and/or processing of structures illustrated and described herein as well as in association with other structures not illustrated.

The method 2 involves forming a via or trench downward through a dielectric layer and an underlying lower SiC layer so as to expose a conductive feature beneath the SiC. Although described herein in association with forming a via, the methods of the present invention, including the exemplary method 2 are also applicable to formation of single damascene trenches. Typically, the lower SiC layer is formed beneath the OSG material to act as an etch-stop layer during formation (e.g., etching) of the via opening or cavity through the OSG layer. An upper SiC layer may be provided over the OSG dielectric layer, which serves as a hard mask layer and is also etched in forming the via. Beginning at 4, the via formation method 2 comprises forming a via pattern at 6 over an upper SiC layer, which leaves a portion of the BARC material exposed in a prospective via region of a semiconductor wafer.

At 8, the upper SiC layer is removed in the prospective via region to expose a portion of the OSG layer using a first etch process, wherein hydrogen-containing gases may be employed to increase SiC etch rate and improve SiC etch selectivity to the underlying OSG dielectric film. In one example, the first etch process at 8 comprises a reactive ion etch (RIE) process performed at a pressure of about 50 mT, and RF power of about 500 W, using an O₂ gas flow of about 20 sccm, an Ar gas flow of about 100 sccm, and a CH₂F₂ gas flow of about 20 sccm to remove the upper SiC layer in the prospective via region. Other etch chemistries are possible within the scope of the invention, for example, wherein the first etch process at 8 may employ other hydrogen-containing gasses such as H₂, CHF₃, CH₃F, HF, or equivalents, alone or in combination. The BARC is etched prior to the hard mask etch using the same or different process as the hard mask etch.

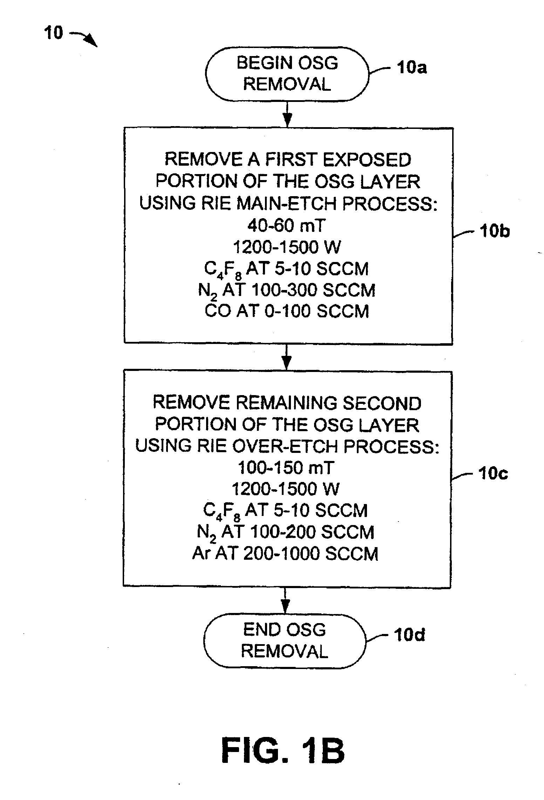

At 10, an exposed portion of the OSG layer is removed to expose a portion of a lower SiC layer in the prospective via region using a second etch process substantially to totally free of hydrogen. The inventors have found that limiting or controlling hydrogen content in the second etch improves the etch selectivity to SiC, such as by using an etch chemistry substantially to totally free of hydrogen, thereby facilitating operation of the lower SiC layer as an etch-stop layer. As described below with respect to Fig. 1B, one example of the second etch process at 10 comprises a two-step process having different etch chemistries for each such step. At 12 of Fig. 1A, the exposed portion of the lower SiC layer is removed in order to expose a portion of a conductive feature underlying the lower SiC, for example, using a third etch process employing a hydrogen-containing gas, after which the via formation process 2 ends at 14.

Referring also to Fig. 1B, further details of one exemplary second etch process (e.g., at 10 of Fig. 1A above) is illustrated, comprising a two-step OSG etch beginning at 10a. At 10b, a first exposed portion of the OSG dielectric layer is removed, leaving a second portion unetched, using an initial or main-etch step or process. Thereafter at 10c, a final or over-etch step is performed to remove the remaining second OSG portion using an etch chemistry substantially to totally free of hydrogen, before the OSG removal process 10 ends at 10d. In one example, the main-etch process at 10b comprises performing an RIE etch at a pressure of about 40 to 60 mT, and RF power of about 1200 to 1500 W, using a C₄F₈ gas flow of about 5 to 10 sccm, a N₂ gas flow of about 100 to 300 sccm, and a CO gas flow of about 0 to 100 sccm to remove the first OSG portion. An example of an over-etch process at 10c comprises performing an RIE etch at a pressure of about 100 to 150 mT, and RF power of about 1200 to 1500 W, using a C₄F₈ gas flow of about 5 to 10 sccm, a N₂ gas flow of about 100 to 200 sccm, and an Ar gas flow of about 200 to 1000 sccm to remove the second portion of the OSG dielectric layer.

It has been proposed that high polymerizing gasses such as C₄F₈, C₅F₈, and C₄F₆ can be used to increase selectivity to SiC, wherein the more polymer in the etch gas, the higher the selectivity. However, the inventors have found that hydrogen content plays an important role in the selectivity between SiC and OSG materials and the etch rates thereof, and may have a more significant impact on the etch selectivity than does the mere use of polymerizing gasses. In particular, it has been appreciated by the inventors that high polymerizing gasses which include hydrogen such as H₂, CHF₃, CH₂F₂, CH₃F, HF, or equivalents, may increase SiC etch rate, and increase the etch selectivity to OSG, FSG, or ultra low-k dielectrics. While not wishing to be bound to a particular theory, it is believed that the hydrogen content in the etch gasses depletes carbon in SiC films, thereby enhancing the SiC etch rate.

Thus, with the proper selection of etch gasses, the SiC etch rate and selectivity with respect to materials such as OSG, FSG, or ultra low-k dielectrics, can be carefully controlled in accordance with the invention, depending on the etch applications. The inventors have also appreciated that the use of polymerizing gasses to increase SiC selectivity is not always successful, whereas the control over hydrogen content is believed to provide consistent control over etch rates and selectivities in such applications. Moreover, the control of SiC etch rates possible using hydrogen-containing gasses finds application in association with deep etch processes, for example, such as microelectromechanical systems (MEMS) in accordance with the invention.

One aspect of the present invention advantageously provides for employing hydrogen-containing gas in the etch gasses when etching through one or both of the SiC layers (e.g., an upper SiC hard mask etch and/or a lower SiC etch-stop etch in the illustrated example) during via or trench formation. In this regard, the invention may be employed to control the hydrogen content of the first and/or third etch processes (e.g., at 8 and/or 12, respectively, in Fig. 1A), such as via an etch chemistry employing hydrogen-containing gas, in order to achieve a desired etch selectivity of SiC material over OSG. In this regard, the invention provides for using any hydrogen-containing etch gasses, such as H₂, CHF₃, CH₂F₂, CH₃F, HF, or the like, alone or in combination, during SiC etching.

In one experiment, a baseline etch-stop RIE etch process was modified with hydrogen, and the resulting etch selectivity (the ratio of SiC etch rate to OSG etch rate) was compared with the baseline selectivity. The baseline etch involved RIE etching at a pressure of about 160 mT, and RF power of about 400 W, employed a CF₄ gas flow of about 10 sccm, a N₂ gas flow of about 200 sccm, an Ar gas flow of about 300 sccm, and a CHF₃ gas flow of about 10 sccm, and was modified by addition of H₂ gas. In this experiment, it was found that the selectivity to OSG was increased by the addition of the H₂ gas, wherein the addition of H₂ gas flow of about 150 sccm provided more than 40% increase in the etch selectivity to OSG during SiC etch-stop layer removal.

Another aspect of the invention provides controlling the hydrogen content of the second etch process (e.g., 10 of Fig. 1A), or other dielectric etch steps, such as by employing an over-etch chemistry substantially to totally free of hydrogen in 10c, to achieve a desired etch selectivity of OSG over SiC. For example, in the over-etch process at 10c of Fig. 1B, this facilitates stopping the second etch process on the lower SiC etch-stop layer while forming a via. These and other aspects of the invention may be carried out in association with via or trench formation in any type of interconnect process, including but not limited to single and dual damascene processes.

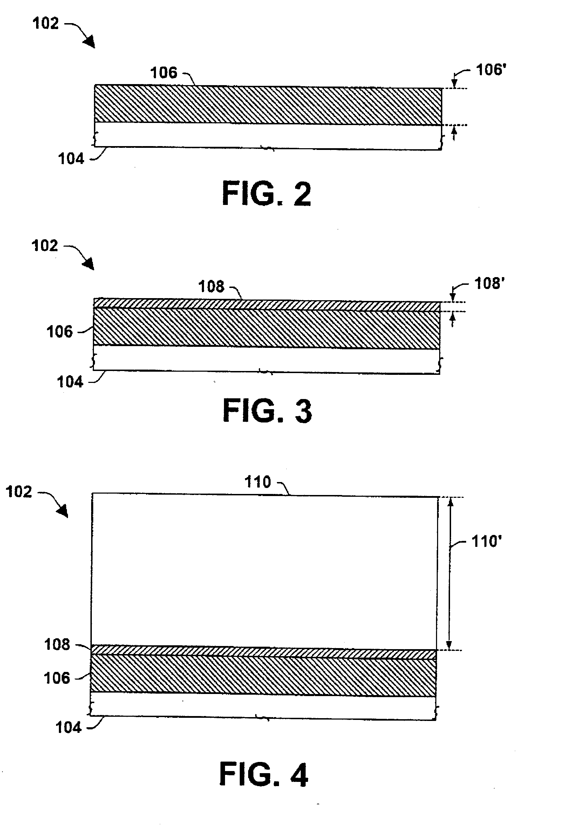

Figs. 2-14 illustrate one such implementation, wherein a via is formed in a semiconductor device for connecting a conductive feature in a first level, with a second level. The illustrated portions of the interconnect process involve the use of OSG dielectrics, and SiC hard mask and SiC etch-stop layers, for use in forming vias to be filled with copper. However, it is noted at this point that the invention is not limited to such specific applications, and further that the structures illustrated and described hereinafter are not necessarily drawn to scale.

In Fig. 2, a semiconductor device 102 is illustrated at an intermediate stage of fabrication processing, wherein one or more electrical devices (e.g., transistors, memory cells, etc., not shown) have been formed on or in a substrate 104, such as silicon. In order to interconnect such devices, and/or to provide external connections thereto, interconnect processing is employed to fabricate one or more levels of copper connection metal lines for forming a desired circuit. Copper-filled vias are formed to vertically provide electrical connections from one such level to another, wherein insulative dielectric material is formed between such trenches and vias to isolate unconnected conductive features from one another.

A conductive feature 106 is formed over the substrate 104 in Fig. 2, having a thickness 106' of about 3000 Å, and a first or lower SiC layer 108 is formed in Fig. 3 over the conductive feature 106, to a thickness 108' of, for example, about 600 Å. The conductive feature 106 may be copper, wherein the via is provided to connect the feature 106 to a first interconnect level. Alternatively, the feature 106 may be a copper-filled trench formed in an interconnect level, which is to be connected to a subsequent interconnect level by forming and filling a via with copper or other conductive material. Thus, the invention finds utility in forming vias for use in any such interconnect levels in a semiconductor device, wherein the lower SiC layer 108 may operate to provide an etch-stop layer or surface during via cavity formation by etch processes in accordance with the invention.

In Fig. 4, a dielectric layer 110 is formed by deposition of organo-silicate-glass (OSG) material to a thickness 110' of, for example, about 5000 Å over the lower SiC layer 108. Any appropriate deposition process may be employed in forming the OSG layer 110 as are known. In operation, the OSG layer 110 provides insulation between overlying and underlying conductive features, such as between the feature 106 and later-formed features above or in trenches in the OSG layer 110, except where connected by via structures formed through the OSG material 110. In this regard, it is noted that OSG material provides relatively low dielectric constant characteristics desirable in avoiding or mitigating RC delays and cross-talk between signals in the finished integrated circuit of the device 102. In addition, it will be appreciated that any dielectric materials may be used in forming the layer 110, including but not limited to OSG, FSG, ultra low-k dielectrics, or the like, wherein the invention is not limited to use in association with OSG materials discussed herein.

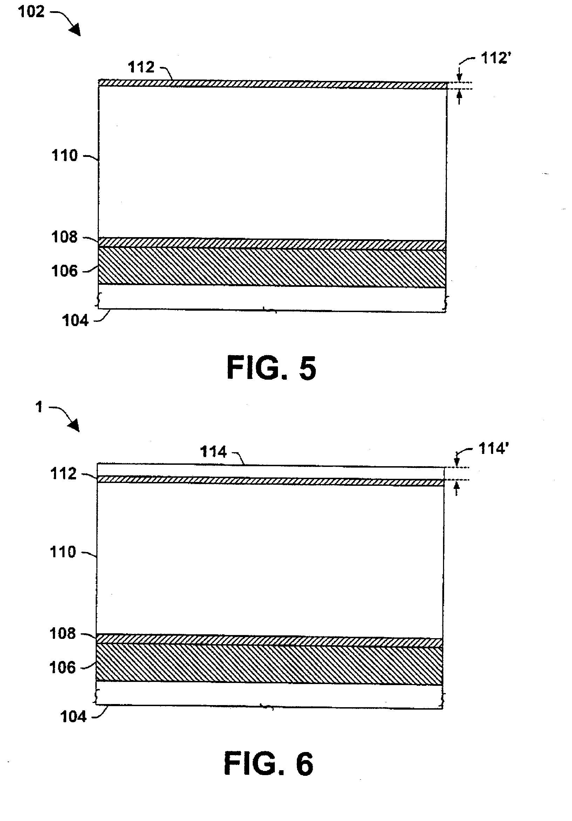

Thereafter in Fig. 5, a second or upper SiC layer 112 is formed, such as through deposition of SiC material to a thickness 112' of, for example, about 400 Å over the OSG dielectric layer 110. The upper SiC layer 112 may serve as a hard mask layer, for example, used in trench formation in a dual damascene type interconnect process while forming overlying trenches for interconnection of copper metal lines with vias formed through the OSG layer 110. In Fig. 6, a bottom anti-reflection coating (BARC) layer 114 is formed over the SiC layer 112 to a thickness 114' of, for example, about 800 Å. The BARC layer 114 operates to facilitate critical dimension (CD) control by preventing or mitigating reflective notching, standing wave effects, and swing ratio caused by thin film interference during photolithographic patterning used in forming features such as vias, trenches, and the like during the interconnect process.

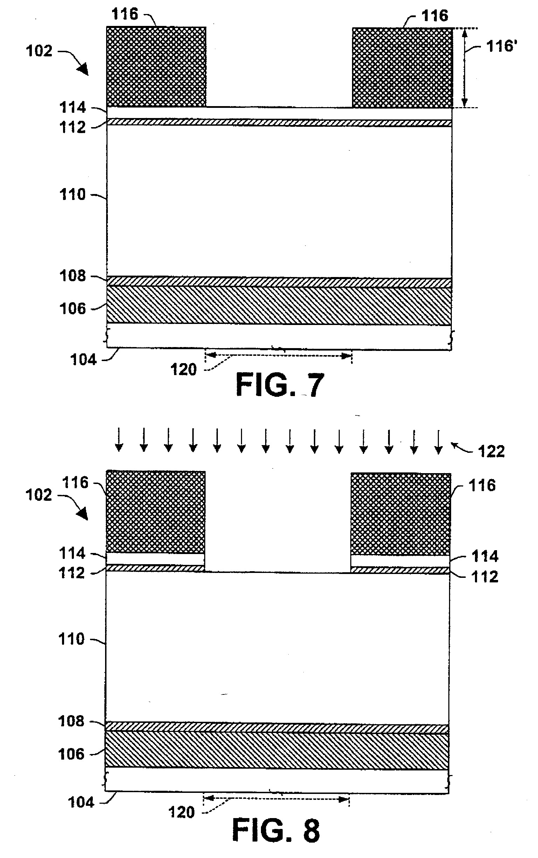

In Fig. 7, a resist pattern 116 is formed over the BARC layer 114, such as by coating a photoresist and patterning the photoresist to expose a portion thereof in a prospective via region 120 of the semiconductor device 102 using photolithographic techniques as are known. A first etch process 122 is then performed in Fig. 8 to remove portions of the BARC layer 114 and the upper SiC layer 112, leaving a portion of the OSG layer 110 exposed in the prospective via region 120. In accordance with an aspect of the invention, the first etch process 122 in the illustrated implementation may employ an RIE etch chemistry having a hydrogen-containing gas or gasses, such as H₂, CHF₃, CH₂F₂, CH₃F, HF, or the like, alone or in combination, during etching of the upper SiC material in the layer 112. In one example, the etch process 122 may use a pressure of about 50 mT, and RF power of about 500 W, using an O₂ gas flow of about 20 sccm, an Ar gas flow of about 100 sccm, and a CH₂F₂ gas flow of about 20 sccm to remove the upper SiC layer 112, thereby exposing the portion of the OSG layer 110 in the prospective via region 120. In this regard, the BARC layer 114 may be etched prior to or during the SiC hard mask etch process 122.

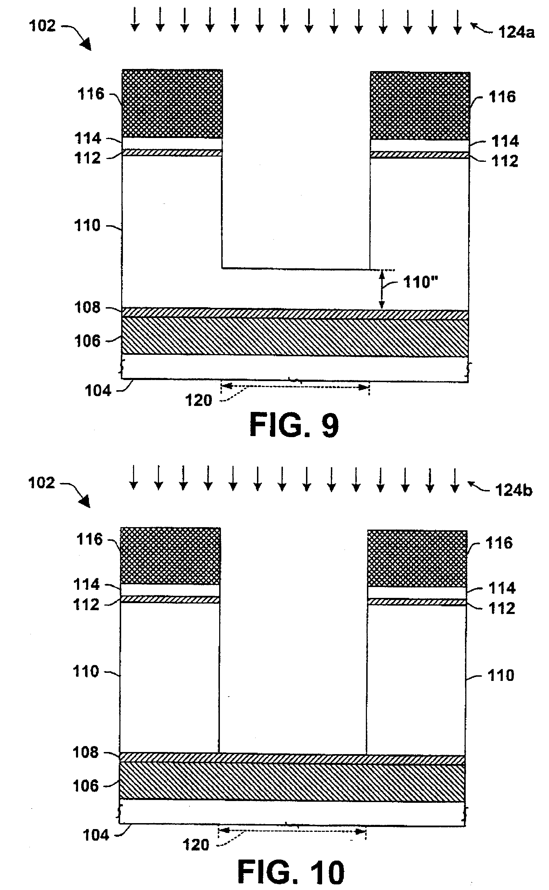

In Figs. 9 and 10, a second etch process 124 is performed to remove the exposed portion of the OSG layer 110 thereby exposing a portion of the lower SiC layer 108 in the region 120. The exemplary second etch process 124 comprises removing a first exposed portion of the OSG layer 110 leaving a second portion of thickness 110" of, for example, about 1500 Å remaining unetched using a main-etch process 124a, as illustrated in Fig. 9, wherein the main-etch process 124a may, but need not be substantially to totally free of hydrogen. A final or over-etch process 124b is then performed in Fig. 10 to remove the remaining second portion of the OSG layer 110, exposing the lower SiC layer 108 in the via region 120, wherein the over-etch process 124b is substantially to totally free of hydrogen. In accordance with the present invention, the hydrogen content of the various etch processes may be advantageously controlled so as to achieve a desired etch rate and/or etch selectivity with respect to SiC and/or OSG type materials or their equivalents.

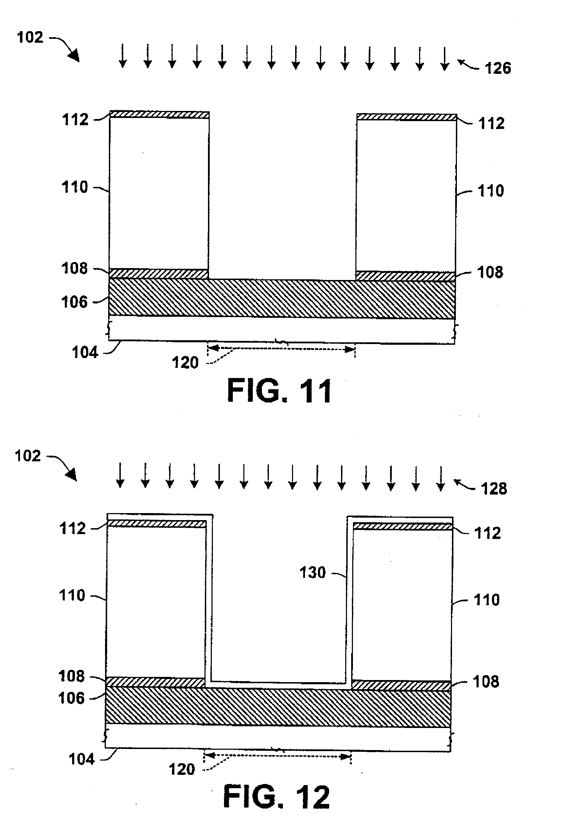

In the illustrated implementation of the current invention, the main-etch process 124a in Fig. 9 comprises performing a reactive ion etch (RIE) at a pressure of about 40 to 60 mT, and RF power of about 1200 to 1500 W, using a C₄F₈ gas flow of about 5 to 10 sccm, a N₂ gas flow of about 100 to 300 sccm, and a CO gas flow of about 0 to 100 sccm to remove the first exposed portion of the OSG layer 110. The exemplary over-etch process 124b of Fig. 10 comprises a reactive ion etch at a pressure of about 100 to 150 mT, and RF power of about 1200 to 1500 W, using a C₄F₈ gas flow of about 5 to 10 sccm, a N₂ gas flow of about 100 to 200 sccm, and an Ar gas flow of about 200 to 1000 sccm to remove the second portion of the OSG layer 110. Following the OSG etch process 124, other processing steps may be performed before etching through the etch-stop layer 108. For example, the remaining photoresist 116 and the BARC layer 114 may be removed using ashing or wet cleaning steps (not shown) as illustrated in Fig. 11.

A third etch process 126 is then performed to remove the exposed portion of the lower SiC layer 108, leaving a portion of the conductive feature 106 exposed in the via region 120. The top SiC hard mask may or may not be fully removed during the third etch process 126. In accordance with the invention, the third etch process 126 may comprise an RIE etch employing a hydrogen-containing gas, such as one or more of H₂, CHF₃, CH₂F₂, CH₃F, HF, in combination with other gasses, and further cleaning steps (not shown) may be employed to remove polymer residue from the etch-stop etch process 126. In another implementation, the resist mask 116 and the BARC layer 114 may be removed (e.g., stripped) after the etch-stop etch process 126. In the illustrated process, the via is filled with copper prior to trench formation. However, because copper tends to diffuse in some materials, leading to processing and performance difficulties, a diffusion barrier 130 is first formed, as illustrated in Fig. 12.

In Fig. 12, a deposition process 128 is performed to deposit a diffusion barrier layer material 130 over the remaining portions of the upper SiC hard mask layer 112, the exposed portion of the conductive feature 106, and the sidewalls of the via. The diffusion barrier 130 operates to prevent or inhibit diffusion of subsequently deposited copper from the via into the OSG layer 110, and may be deposited using any appropriate deposition processes 128 as are known. Any appropriate materials may be used in forming the diffusion barrier, such as Ta/TaN, or others as are known. A seed copper layer (not shown) may then be deposited over the diffusion barrier 130, in order to facilitate subsequent copper filling of the via.

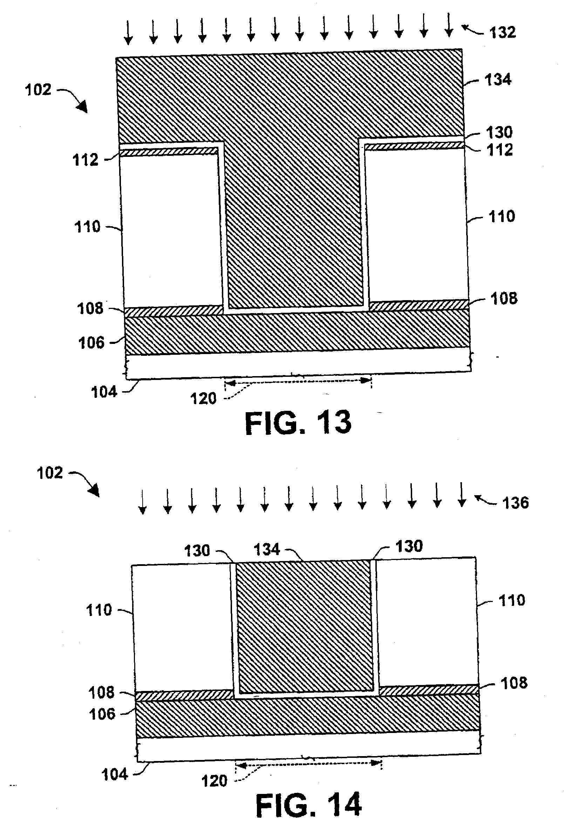

In Fig. 13, an electro-chemical deposition (ECD) process 132 is used to deposit a copper layer 134 over the device 102 so as to fill the via cavity, as well as over the barrier layer 130. Any appropriate copper deposition process 132 may be employed, which may be a single step or a multi-step process. Thereafter in Fig. 14, a chemical mechanical polishing (CMP) process 136 is employed to planarize the upper surface of the device 102, reducing the OSG layer 110, the diffusion barrier 130 and the deposited copper 134 as illustrated. In this manner, the planarization process 136 electrically separates the illustrated via from other such vias formed in the device 102, whereby controlled connection of the underlying conductive feature 106 with subsequently formed interconnect structures can be achieved.

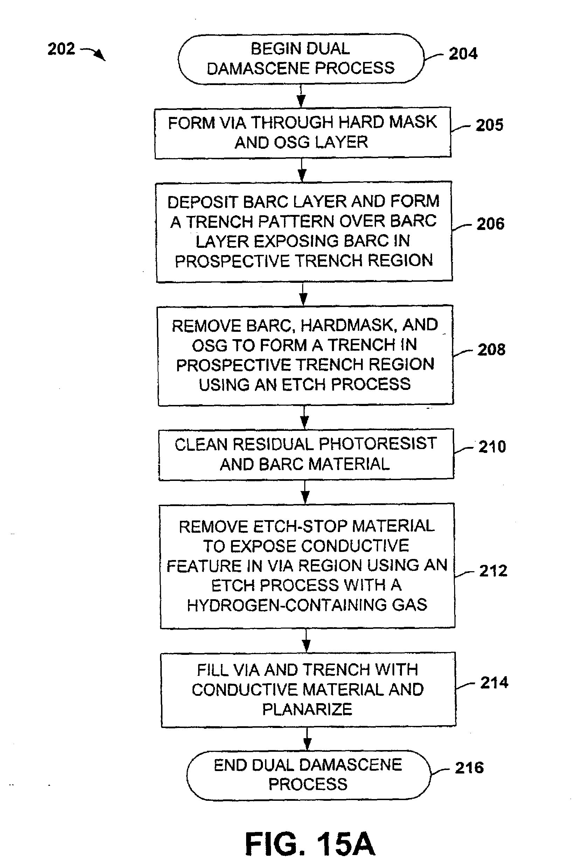

It will be appreciated by those skilled in the art that the above methodologies may be employed in forming vias as part of single or dual damascene interconnect processes. Furthermore, it is to be understood that the above process can be employed during trench formation, for example, in a single damascene trench formation process. As illustrated and described hereinafter with respect to Figs. 15A-21, the various aspects of the invention may be applied in a dual damascene integration scheme.

Referring now to Figs. 15A and 15B, another aspect of the invention provides for controlling etch chemistry hydrogen content in association with formation of dual damascene type interconnect. In Fig. 15A, one exemplary method 202 is illustrated for forming a dual damascene via and trench structure in accordance with the present invention, wherein hydrogen content may be advantageously controlled in various etch steps used in creating via and/or trench openings to achieve a desired selectivity between SiC and OSG or other dielectric material.

Although the method 202 is illustrated and described below as a series of acts or events, it will be appreciated that the present invention is not limited by the illustrated ordering of such acts or events. For example, some acts may occur in different orders and/or concurrently with other acts or events apart from those illustrated and/or described herein, in accordance with the invention. In addition, not all illustrated steps may be required to implement a methodology in accordance with the present invention. Furthermore, the methods according to the present invention may be implemented in association with the formation and/or processing of structures illustrated and described herein as well as in association with other structures not illustrated.

Beginning at 204, the method 202 comprises forming a via through a hard mask layer and an OSG layer at 205. The via may be formed at 205 using etch processes illustrated and described above, such as by etching portions of a SiC hard mask layer using an etch process comprising a hydrogen-containing gas, and etching the OSG using an etch process substantially to totally free of hydrogen to form a via cavity down to an underlying SiC etch-stop layer. At 206, a BARC layer is deposited, and a trench pattern is formed over the BARC layer, SiC hard mask, and the underlying OSG, leaving a portion of the BARC material exposed in a prospective trench region. At 208, the exposed BARC material, the hard mask, and a portion of the OSG material is removed in the trench region using etch processes to form a trench extending into the OSG layer. An intermediate etch-stop layer, such as SiC may optionally be used to define the trench depth, in which case the OSG trench etch process at 208 may comprise an etch chemistry substantially to totally free of hydrogen to provide desired etch selectivity to such intermediate SiC etch-stop layer.

Thereafter at 210, a cleaning step is performed, such as comprising an ashing process and/or a wet clean operation, to remove any residual photoresist and BARC material and thereby to expose the underlying SiC etch-stop layer in the via region. The etch-stop layer is etched at 212 to expose an underlying conductive feature, such as using an etch process employing one or more hydrogen-containing gasses. Thereafter at 214, the via and trench are filled through deposition of a conductive material such as copper, and the device is planarized before the method 202 ends at 216. The filling process at 214 may also comprise formation of a diffusion barrier to prevent or inhibit diffusion of subsequently deposited copper from the via or the trench into the OSG layer or layers. In the various etch processes of the method 202, the invention provides for control of hydrogen content so as to advantageously achieve a desired etch rate and/or etch selectivity. It is noted at this point that while illustrated and described in the context of OSG dielectric materials and etching thereof, the invention finds application in association with structures employing other dielectric materials, such as FSG, ultra low-k dielectrics, and the like.

As noted above, the method 202 involves controlling hydrogen content of the etch chemistry to achieve a desired selectivity between SiC and OSG or other dielectric. Referring also to Fig. 15B, an example of hydrogen content control is illustrated for the OSG etch process at 205 to form the dual damascene via. The dielectric etch process at 205 may comprise a multi-step process for removal of OSG material beginning at 205a, particularly where an intermediate SiC trench etch-stop layer is provided in the semiconductor device between upper and lower dielectric layers.

At 205b, a first exposed portion of the OSG dielectric layer is removed, leaving a second portion unetched, using an initial etch process. In one example, the initial etch process at 205b comprises performing an RIE etch at a pressure of about 40 to 60 mT, and RF power of about 1200 to 1500 W, using a C₄F₈ gas flow of about 5 to 10 sccm, a N₂ gas flow of about 100 to 300 sccm, and a CO gas flow of about 0 to 100 sccm to remove the first OSG portion. Thereafter at 205c, a final etch step or process is performed to remove the remaining second OSG portion using an etch chemistry substantially to totally free of hydrogen, before the via OSG removal process 205 ends at 205d. An example of a final etch process at 205c comprises performing an RIE etch operation at a pressure of about 100 to 150 mT, and RF power of about 1200 to 1500 W, using a C₄F₈ gas flow of about 5 to 10 sccm, a N₂ gas flow of about 100 to 200 sccm, and an Ar gas flow of about 200 to 1000 sccm to remove the second portion of the OSG layer.

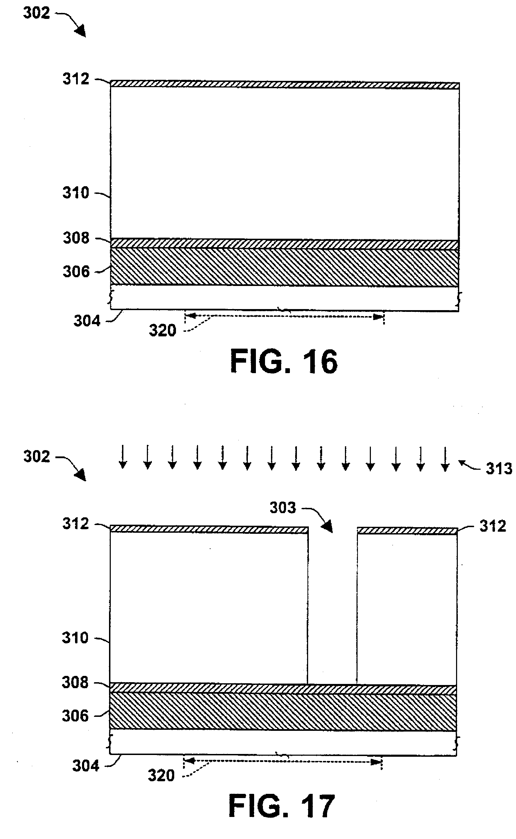

Figs. 16-21 illustrate another exemplary implementation of the invention, wherein a dual damascene structure is formed in a semiconductor device 302 for filling with copper to form interconnections between electrical devices in an integrated circuit. The illustrated portions of the interconnect process involve the use of OSG dielectrics, and SiC layers, for use in providing vias and trenches to be filled with copper. However, it is noted at this point that the invention is not limited to such specific applications, and further that the structures illustrated and described hereinafter are not necessarily drawn to scale. Moreover, the above described techniques for single damascene via formation may be employed as an initial step in forming vias in the dual damascene process described below in accordance with the invention.

In Fig. 16, a semiconductor device 302 is illustrated at an intermediate stage of fabrication processing using dual damascene interconnect techniques. In the illustrated device 302, a conductive feature 306 is formed over the substrate 304. A lower SiC layer 308 overlies the conductive feature 306 to act as an etch-stop layer in formation of a prospective via. A dielectric layer 310, such as formed from OSG, FSG, ultra low-k dielectric materials, or the like, overlies the etch-stop layer 308, and an upper SiC hard mask layer 312 overlies the OSG layer 310. Optionally, the OSG layer 310 may comprise two layers of OSG material, with an intermediate SiC trench etch-stop layer (not shown) formed therebetween, so as to control the trench depth. In Fig. 17, an etch process 313 is performed to form a via cavity 303 through the layers 312 and 310 to expose a portion of lower SiC layer 308 in the via region. The etch process 313 may be a single-step process or a multi-step process, wherein the last etch step employs an etch chemistry substantially to totally free of hydrogen as described above.

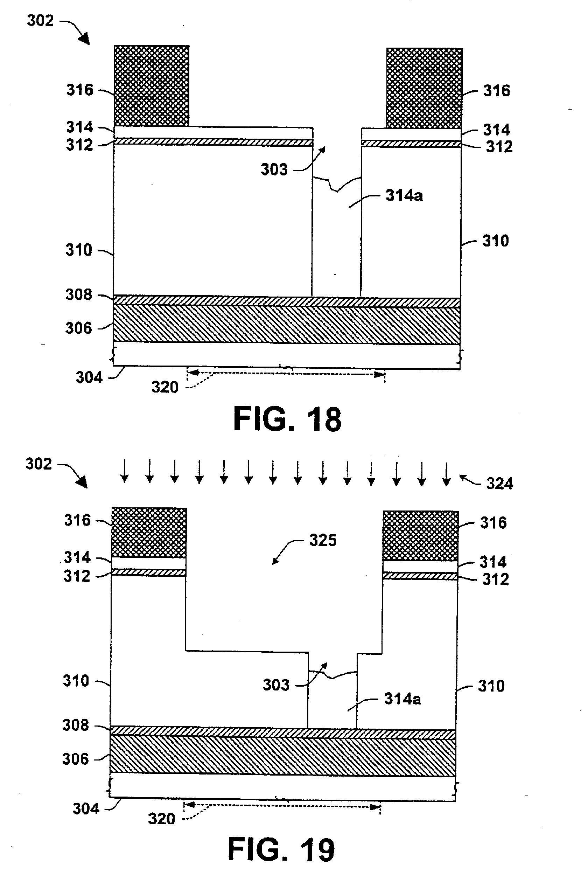

In Fig. 18, a BARC layer 314 is deposited over the SiC hard mask 312 and the OSG layer 310, resulting in a portion 314a of BARC material being formed in the bottom of the via cavity 303. A photoresist 316 is then formed over the BARC layer 314, leaving a prospective trench region 320 in the device 302 exposed. In Fig. 19, an etch process 324 is performed to remove an exposed portion of the BARC layer, hard mask, and OSG layer 310 to form a trench 325. During the etch process 324, a hydrogen content thereof may be controlled according to the invention, such as where the process 324 is substantially to totally free of hydrogen. For example, where an optional intermediate SiC etch-stop layer (not shown) is used, control of the hydrogen content in the last step of the etch process 324 facilitates stopping of the OSG etch on SiC by controlling etch selectivity between OSG and SiC. In addition, as noted above, the exemplary process 324 may comprise one or more RIE etch steps, although other etch processes are contemplated within the scope of the invention.

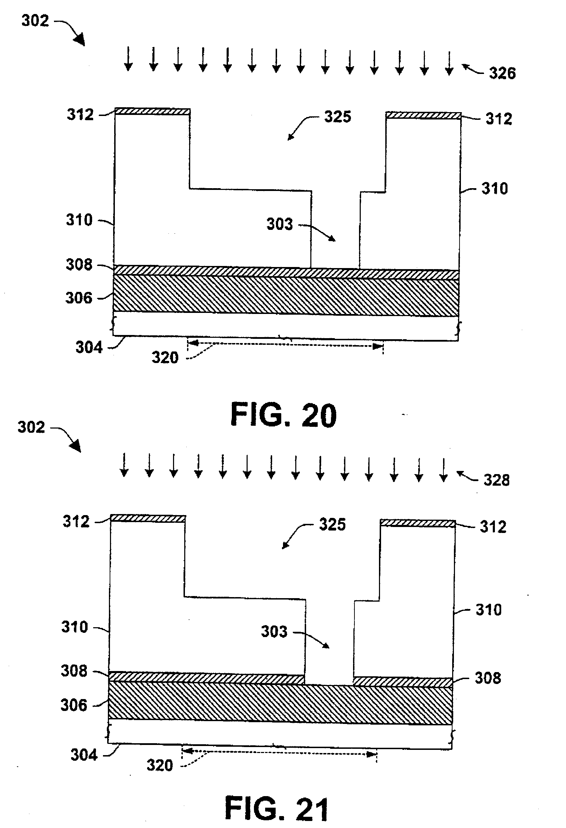

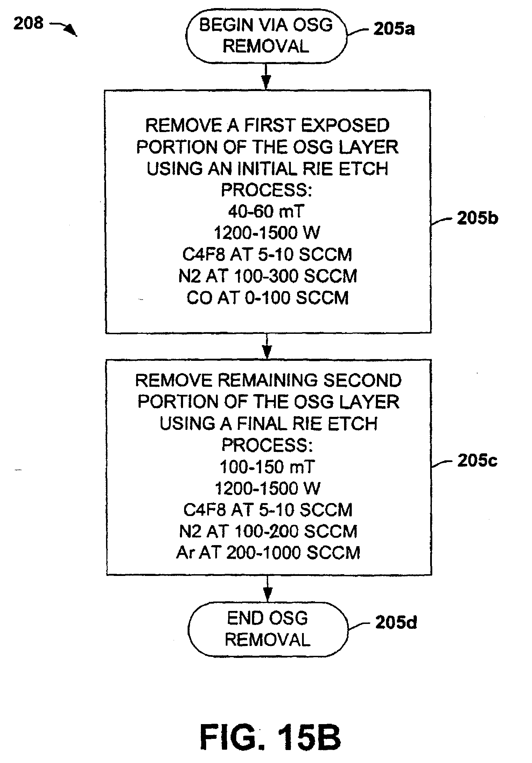

Referring now to Fig. 20, after the formation of the trench 325, the remaining resist 316 and BARC layer 314 are removed along with the remaining portion of the BARC material 314a in the bottom of the via cavity 303, for example, using ashing and/or wet cleaning operations 326. In Fig. 21, an etch-stop etch process 328 is performed employing an etch chemistry with one or more hydrogen-containing gasses, to remove the exposed portion of the lower SiC layer 308, thereby exposing the conductive feature 306 in the via 303. The top SiC hard mask may or may not be fully removed during the etch-stop etch 328. Thereafter, a diffusion barrier (not shown) may be deposited over the device 302, including the exposed portion of the conductive feature 306, and the sidewalls of the via 303 and the trench 325 to prevent or inhibit diffusion of subsequently deposited copper from the via 303 and the trench 325 into the OSG layer 310. A seed copper layer (not shown) may then be deposited over the barrier layer, and an electro-chemical deposition (ECD) process is then performed to deposit copper material (not shown) over the device 302 so as to fill the via cavity 303 and the trench 325, followed by chemical mechanical polishing (CMP) to planarize the upper surface of the device 302.

Although the invention has been illustrated and described with respect to one or more implementations, equivalent alterations and modifications will occur to others skilled in the art upon the reading and understanding of this specification and the annexed drawings. In particular regard to the various functions performed by the above described components (assemblies, devices, circuits, systems, etc.), the terms (including a reference to a "means") used to describe such components are intended to correspond, unless otherwise indicated, to any component which performs the specified function of the described component (e.g., that is functionally equivalent), even though not structurally equivalent to the disclosed structure which performs the function in the herein illustrated exemplary implementations of the invention. In addition, while a particular feature of the invention may have been disclosed with respect to only one of several implementations, such feature may be combined with one or more other features of the other implementations as may be desired and advantageous for any given or particular application. Furthermore, to the extent that the terms "including", "includes", "having", "has", "with", or variants thereof are used in either the detailed description and the claims, such terms are intended to be inclusive in a manner similar to the term "comprising."

## Claims

1. A method for forming a conductive via to connect a conductive feature in a first level with a second level through a dielectric layer formed over the conductive feature in a semiconductor device, the method comprising:
removing an exposed portion of the dielectric layer to expose a portion of a lower silicon carbide layer in a prospective via region underlying the dielectric layer using an etch process substantially to totally free of hydrogen;
removing the exposed portion of the lower silicon carbide layer to expose a portion of the conductive feature underlying the lower silicon carbide; and
forming a conductive material over the semiconductor device so as to fill a via cavity created by the etch processes, the conductive material providing electrical connection to the conductive feature.

2. The method of claim 1, further comprising:
removing a portion of an upper silicon carbide layer overlying the dielectric layer in the prospective via region of the semiconductor device to expose a portion of the dielectric layer using a first etch process employing a hydrogen-containing gas prior to the step of removing the exposed portion of the dielectric layer;
wherein removing the exposed portion of the dielectric layer comprises using a second etch process substantially to totally free of hydrogen.

3. The method of claim 1 or 2, wherein removing the exposed portion of the lower silicon carbide layer comprises using a third etch process employing a hydrogen-containing gas.

4. The method of claim 2 or 3, wherein the second etch process comprises:
removing a first exposed portion of the dielectric layer leaving a second portion of the dielectric layer unetched using a main-etch process; and
removing the second portion of the dielectric layer to expose the portion of the lower silicon carbide layer in the prospective via region using an over-etch process substantially to totally free of hydrogen.

5. The method of claim 1, wherein removing the exposed portion of the dielectric layer comprises:
removing a first exposed portion of the dielectric layer leaving a second portion of the dielectric layer unetched using a main-etch process; and
removing the second portion of the dielectric layer to expose the portion of the lower silicon carbide layer in the prospective via region using an over-etch process substantially to totally free of hydrogen.

6. The method of any one of claims 1 to 5, wherein the dielectric layer comprises one of OSG, FSG, and an ultra low-k dielectric material.

7. A method of forming a cavity in a dual damascene interconnect process, the method comprising:
forming a silicon carbide layer over a conductive feature;
forming a dielectric layer over the etch-stop layer;
forming a hard mask layer over the dielectric layer;
forming a resist pattern over the hard mask layer, the resist pattern exposing the hard mask layer in a prospective cavity region;
etching the exposed hard mask layer to expose the dielectric material in the prospective cavity region; and
removing an exposed portion of the dielectric layer to expose a portion of a silicon carbide layer in the prospective cavity region using an etch process substantially to totally free of hydrogen.

8. The method of claim 7, further comprising:
removing the exposed portion of the silicon carbide layer to expose a portion of the conductive feature in the prospective cavity region; and
forming a conductive material over the semiconductor device so as to fill a cavity created by the etch processes, the conductive material providing electrical connection to the conductive feature.
